# EUROPÄISCHE PATENTSCHRIFT

(11) **EP 1 253 808 B1**
(45) Veröffentlichungstag und Bekanntmachung des Hinweises auf die Patenterteilung: **21.12.2005**
(21) Anmeldenummer: 02017608.7
(22) Anmeldetag: 23.05.2000
(51) Int. Cl.: B60H 1/22

(54) **Elektrische Heizvorrichtung, insbesondere für den Einsatz in Kraftfahrzeugen**
Electrical heating device, in particular for use in vehicles
Dispositif de chauffage électrique, utilisé en particulier dans les véhicules

(43) Veröffentlichungstag der Anmeldung: 30.10.2002
(62) Teilanmeldung aus: 00111120.2
(73) Patentinhaber: Catem GmbH & Co.KG, 76863 Herxheim bei Landau/Pfalz (DE)
(72) Erfinder: Beetz, Klaus, Dr., 76149 Karlsruhe (DE); Bohlender, Franz, 76870 Kandel/Pfalz (DE)
(74) Vertreter: Grünecker, Kinkeldey, Stockmair & Schwanhäusser Anwaltssozietät

(56) Entgegenhaltungen:
- EP-A- 0 901 311
- EP-A- 0 937 595
- DE-A- 19 848 169
- US-A- 5 549 153

## Beschreibung

Die Erfindung bezieht sich auf eine elektrische Heizvorrichtung zur Lufterwärmung, die sich insbesondere für den Einsatz als elektrische Zusatzheizung in Kraftfahrzeugen eignet.

Bei Kraftfahrzeugen werden Heizvorrichtungen bzw. Radiatoren zur Beheizung des Innenraums und/oder des Motors verwendet. Sie werden einerseits beim Starten des Motors verwendet, solange dieser noch keine ausreichende Wärmeenergie zur Verfügung stellt. Andererseits machen insbesondere verbrauchsoptimierte Verbrennungsmotoren den Einsatz solcher Heizvorrichtungen in Kraftfahrzeugen erforderlich.

Der Einsatz solcher Heizvorrichtungen ist jedoch nicht auf den Kraftfahrzeugbereich beschränkt. Sie sind auch für eine Vielzahl anderer Einsatzzwecke geeignet, beispielsweise im Bereich von Hausinstallationen (Raumklimatisierung), Industrieanlagen u.dgl.

Aus EP-A2-0 901 311 ist eine elektrische Heizeinrichtung für Kraftfahrzeuge bekannt. Die beschriebene Heizvorrichtung umfasst mehrere zu einem Heizblock zusammengesetzte Heizelemente. Der Heizblock wird zusammen mit einer Steuervorrichtung zur Ansteuerung der Heizelemente in einem gemeinsamen Rahmen gehalten. Auf diese Weise bildet die Steuervorrichtung mit dem in dem Rahmen gehaltenen Heizblock eine bauliche Einheit. Die Steuervorrichtung umfasst eine Leistungselektronik mit elektronischen Schaltern, die Kühlkörper aufweisen. Die Steuervorrichtung ist so angeordnet, dass der Hauptteil eines zu erwärmenden Luftstroms den Heizblock durchsetzt und ein Randteil des Luftstroms die Steuervorrichtung zur Kühlung anströmt.

Aufgabe der Erfindung ist es, eine elektrische Heizvorrichtung anzugeben, die hinsichtlich der Stromzuführung zu einer Leistungselektronik verbessert ist.

Diese Aufgabe wird mit den Merkmalen des Patentanspruchs 1 gelöst.

Gemäß einer bevorzugten Ausführungsform strömt die zu erwärmende Luft nicht die Steuervorrichtung als Ganzes an, sondern durch Fensteröffnungen kann der zur Kühlung der Leistungselektronik verwendete Luftdurchsatz gesteuert werden. Auf diese Weise ist eine Anpassung an den Luftdurchsatz des Heizblocks möglich, so dass beide eine im Wesentlichen gleiche Ausgangstemperatur aufweisen. Auf diese Weise wird die Effektivität der gesamten Heizvorrichtung nicht durch einen zur Kühlung der Steuerelektronik abgezweigten Luftstrom vermindert.

Eine weitere Erwärmung der Kühlluft lässt sich dann erreichen, wenn diese auch über die Bauelemente der Steuervorrichtung gelenkt wird. Dazu ist die Platine der Steuervorrichtung vorzugsweise nur einseitig mit Bauelementen bestückt. Auf diese Weise lässt sich ein besonders einfaches Anströmen der Bauelemente erreichen. Zudem ist eine solche Anordnung der Bauelemente auch aus fertigungstechnischen Gründen besonders vorteilhaft.

In einer vorteilhaften Ausführungsform der Erfindung ist die Platine senkrecht zur Rahmenebene angeordnet. Eine solche Anordnung ermöglicht einerseits ein einfaches Anströmen der Bauelemente. Andererseits lässt sich auf diese Weise eine geringe Bautiefe der elektrischen Heizvorrichtung erreichen.

Eine besonders einfache Fixierung der Steuervorrichtung lässt sich erreichen, wenn dazu die elektrischen Anschlussfahnen der Heizelemente verwendet werden, die in den Kasten des Seitenholms hineinragen. Dazu können auf der Platine den Anschlussfahnen entsprechende Federelemente vorgesehen sein. Eine solche Ausführungsform ermöglicht, mit denselben Mitteln einerseits eine elektrische Kontaktierung beispielsweise zur Weiterleitung der Ansteuerströme für die Heizelemente, als auch eine mechanische Fixierung vorzunehmen. Damit wird der Materialaufwand und der Herstellungsaufwand für eine erfindungsgemäße elektrische Heizeinrichtung deutlich vermindert.

Weitere vorteilhafte Ausgestaltungen der Erfindung sind in den Unteransprüchen angegeben.

Im folgenden wird die Erfindung anhand der beiliegenden Zeichnungen beschrieben, in denen
Fig. 1a und 1b eine Aufsicht bzw. Seitenansicht einer erfindungsgemäßen elektrischen Heizvorrichtung zeigen,
Fig. 2 eine Detailansicht der mit Bauelementen bestückten Platine der Steuervorrichtung zeigt,
Fig. 3 eine Detailansicht des kastenförmig ausgebildeten Seitenholms und der in diesen einsetzbaren Steuervorrichtung zeigt,
Fig. 4 eine weitere Detailansicht des kastenförmig ausgebildeten Seitenholms und der in diesen einsetzbare Steuervorrichtung zeigt,
Fig. 5a, 5b und 5c Detailansichten einer weiteren Ausführungsform der vorliegenden Erfindung zeigen,
Fig. 6 eine vereinfachte perspektivische Detailansicht einer Realisierung einer weiteren Ausführungsform der Steuervorrichtung gemäß der vorliegenden Erfindung zeigt, und
Fig. 7a, 7b, und 7c verschiedene Detailansichten des Aufbaus der Steuervorrichtung gemäß Fig. 6.

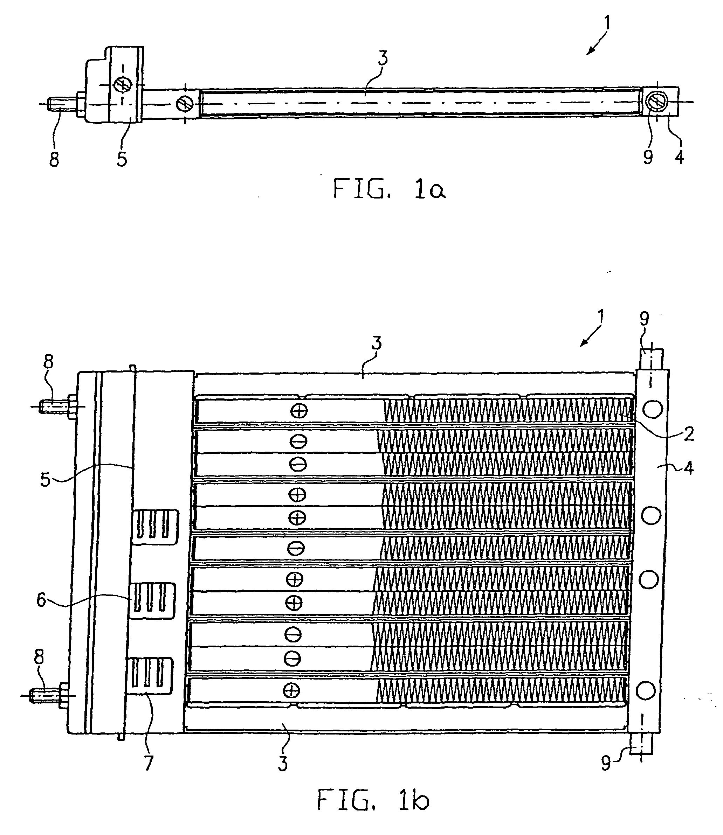

In Fig. 1a ist eine Seitenansicht der erfindungsgemäßen elektrischen Heizvorrichtung 1 gezeigt. Fig. 1b zeigt eine Aufsicht auf die elektrische Heizvorrichtung 1. Die elektrische Heizvorrichtung 1 enthält einen Heizblock, der aus einer Mehrzahl geschichteter oder gestapelter Heizelemente 2 besteht. Jedes Heizelement 2 besteht aus einem Widerstandsheizelement und benachbart dazu angeordneten Radiatoren oder Wärmeleitblechen. Als Widerstandsheizelemente werden vorzugsweise PTC-Elemente verwendet. Der Heizblock aus den Heizelementen 2 wird in einem Rahmen gehalten. Dieser Rahmen besteht aus gegenüberliegenden Längsholmen 3 und senkrecht dazu angeordneten Seitenholmen 4 und 5. Die Holme des Rahmens werden entweder aus Metall oder aus Kunststoff gefertigt.

Während die Längsholme 3 im wesentliche symmetrisch aufgebaut sind, unterscheiden sich die beiden Seitenholme 4 und 5 in der in Fig. 1 dargestellten Ausführungsform.

Im Gegensatz zum Seitenholm 4 ist der Seitenholm 5 als einseitig offener Kasten ausgebildet. Die Öffnung dieses kastenförmigen Seitenholms 5 liegt auf der den Heizelementen 2 gegenüberliegenden Seite des Seitenholms 5. In diesen Kasten ist eine Steuervorrichtung einsetzbar, die die Wärmeabgabe der einzelnen Heizelemente 2 durch Steuerung des den Heizelementen 2 zugeführten Stromes steuert. Die offene Seite des als Kasten ausgebildeten Seitenholms 5 wird nach dem Einsetzen der Steuerschaltung mit einem aufsteckbaren oder aufklipsbaren Deckel verschlossen.

Die Platine 10 der Steuervorrichtung ist nach dem Einsetzen vorzugsweise senkrecht zur Rahmenebene angeordnet, es ist jedoch auch eine parallele Anordnung möglich (nicht dargestellt).

Die Heizvorrichtung 1 wird über zwei Anschlussbolzen 8 mit Strom versorgt. Sie sind so ausgebildet, dass sie problemlos die geforderten Heizströme leiten können. Die Anschlussbolzen 8 ragen in der in Fig. 1 dargestellten Ausführungsform auf der Seite heraus, auf der der kastenförmige Seitenholm 5 offen ist.

Auf derselben Seite ist ein weiterer Steckersockel zur Ansteuerung der Steuervorrichtung vorgesehen, der in Fig. 1 nicht dargestellt ist.

Der Seitenholm 5 weist auf den Seiten, die in der Flächenebene des Rahmens liegen, Fensteröffnungen 7 auf. Diese Fensteröffnungen sind so angeordnet, dass sie ebenfalls in dem zu erwärmenden Luftstrom liegen. Zwischen den sich gegenüberliegenden Fensteröffnungen 7 sind Kühlelemente 6 angeordnet, die zu den Leistungselektronikbauelementen der Steuerschaltung gehören. Beim Betrieb wird nicht nur der Heizblock aus den Heizelementen 2, sondern ebenfalls die Fensteröffnungen von zu erwärmender Luft durchsetzt.

Die Wahl der Größe der Fensteröffnungen 7 erlaubt, den Anteil der Luftmenge zu bestimmen, die an den Kühlelementen 6 vorbeiströmt. Erfindungsgemäß wird der Luftdurchsatz so eingestellt, dass die durch den Heizblock geströmte Luft und die an den Kühlkörpern 6 vorbeigeströmte Luft möglichst geringe Temperaturunterschiede aufweisen. Nur wenn die durch die Fensteröffnungen 7 geströmte Luft in ihrer Temperatur der durch den Heizblock geströmten Luft möglichst nahe kommt, wird eine möglichst hohe Effizienz beim Betrieb der Heizvorrichtung erreicht.

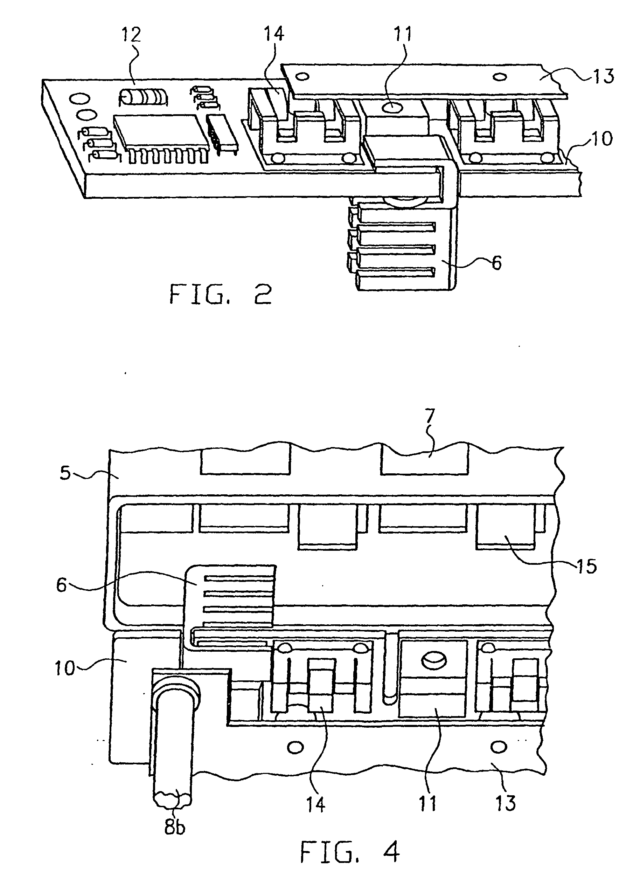

Figur 2 zeigt eine Detailansicht der innerhalb des kastenförmig ausgebildeten Seitenholms angeordneten Steuervorrichtung. Auf einer Platine 10 ist neben den Leistungselektronikbauelementen 11 eine Steuerelektronik 12 vorgesehen. Die Steuerelektronik 12 bestimmt die von den Leistungselektronikbauelementen 11, insbesondere den Leistungstransistoren, an das diesen jeweils zugeordnete Heizelement 2 abzugebende Strommenge. Die Strommenge wird der Steuerschaltung von einem der Anschlussbolzen 8 über eine Leitungsschiene 13 zugeführt. Der Ausgang des Leistungstransistors 11 ist fest mit der Platine 10 verlötet und mit dem diesem Transistor zugeordneten Federelement 14 verbunden.

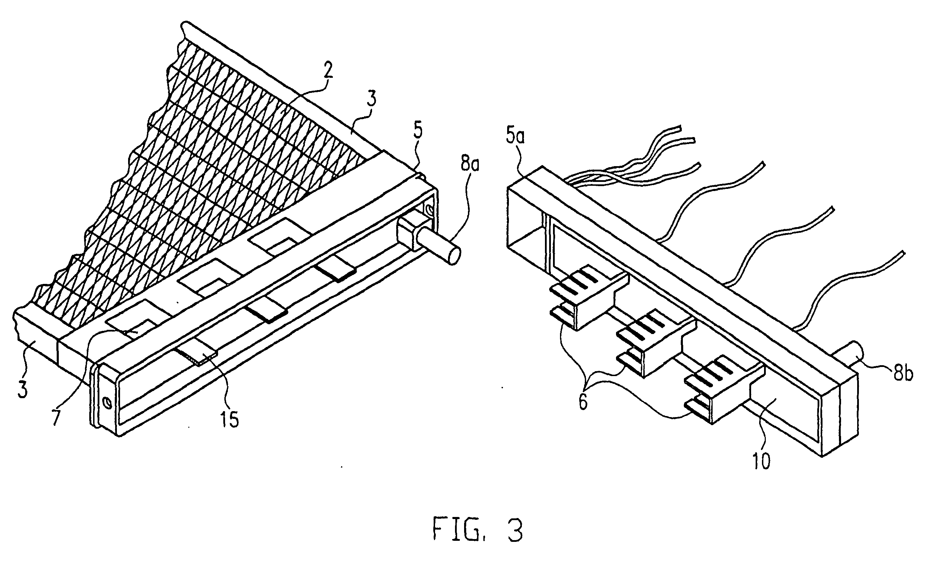

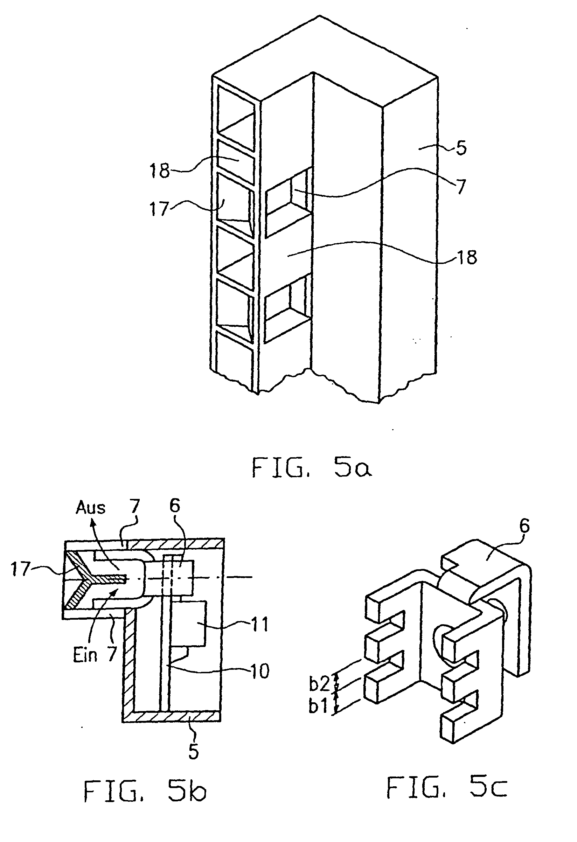

Die Federelemente 14 sind so auf der Platine angebracht, dass sie beim Zusammenstecken der Steuervorrichtung in den Seitenholmen 5 mit Anschlussfahnen der Heizelemente verbunden sind. Solche Anschlussfahnen 15 sind in den Fig. 3 und 4 zu erkennen.

In der dargestellten Ausführungsform werden die Anschlussfahnen 15 durch die Platine 10 in Fig. 2 hindurch in die Federelemente 14 gesteckt. Eine solche Anordnung erlaubt eine feste mechanische Fixierung der Platine 10 mit der Steuerelektronik in dem Rahmen. Gleichzeitig wird eine elektrische Kontaktierung mit den jeweiligen Heizelementen bewirkt.

Die Platine ist nur einseitig mit Bauelementen bestückt. Entsprechend der Anzahl von Heizstufen weist die Platine waagerecht auf dieser befestigte Leistungstransistoren 11 auf. Im gezeigten Ausführungsbeispiel sind drei Heizstufen und dementsprechend drei Leistungstransistoren vorgesehen. Jeder Leistungstransistor 11 ist an seinem Ausgangsanschluss fest mit der Platine 10 verlötet.

Aus dem Transistor ragt eine Anschlussfahne heraus, an der ein Kühlelement 6 befestigt ist. Das Kühlelement 6 ist vorteilhafterweise nicht elektrisch leitend mit dem Heizelement verbunden.

Das Kühlelement 6 weist Kühlrippen auf, die in einer Ebene liegen, die senkrecht auf der Platine steht. Im gezeigten Ausführungsbeispiel sind die Kühlrippen zudem auf der nicht bestückten Seite der Platine angeordnet. Nur ein Schenkel des Kühlelementes 6 ragt auf die bestückte Seite der Platine und ist mit der Anschlussfahne des Transistors 11 verbunden, um die vom Transistor erzeugte Wärme abzuleiten. In der gezeigten Ausführungsform ragt der mit dem Transistor 11 verbundene Schenkel des Kühlelementes 6 durch eine Öffnung in der Platine 10 auf die bestückte Seite der Platine 10. Er kann jedoch ebenfalls über den Rand der Platine ragen, so dass eine Öffnung in der Platine 10 nicht erforderlich ist.

Eine entsprechende Anordnung der Bauelemente von Transistor 11, Federelement 14 und Kühlement 6 ist jeweils für jede Heizstufe auf der Platine vorgesehen.

Figur 3 zeigt eine Detailansicht des kastenförmig ausgebildeten Seitenholms 5 und der in diesen einsetzbaren Steuerschaltung. Der Seitenholm 5 ist auf einer Seite mit den Längsholmen 3 und dem Heizblock mit den Heizelementen 2 verbunden. Auf der Oberseite des Seitenholms 5 sind die fensterförmigen Öffnungen 7 zu erkennen, durch die die zu erwärmende Luft hindurchtritt.

Innerhalb des kastenförmig ausgebildeten Seitenholms 5 sind drei Anschlusslaschen 15 zu erkennen und ein Anschlussbolzen 8a. Dieser Anschlussbolzen stellt die Plusverbindung für alle Heizelemente 2 dar. Zusätzlich ist in dieser Abbildung in perspektivischer Darstellung die Steuervorrichtung 5a zu erkennen, die in den Kasten des Seitenholmes 5 einsetzbar ist. Die Steuervorrichtung 5a wird mit der dem Seitenholm 5 zugewandten Seite in diesen eingesetzt.

Auf den dem Seitenholm 5 zugewandten Seite der Steuerrichtung 5a ist die Unterseite der Platine 10 zu erkennen. Aus dieser Platine 10 ragen drei Kühlelemente 6 heraus. Jedes dieser Kühlelemente bzw. Kühlbleche ist einem der Leistungstransistoren 11 einer Heizstufe zugeordnet.

Zu jedem Kühlelement 6 sind entsprechende Fensteröffnungen 7 in der Oberfläche des Seitenholms 5 vorgesehen. Dadurch wird im Betrieb jedem Kühlelement gezielt ein Luftstrom zugeführt.

Auf der nach außen gewandten Seite ist ein weiterer Anschlussbolzen 8b zu erkennen. Dieser Anschlussbolzen dient als elektrischer Massepol bei der Zuführung von Strom. Der Anschlussbolzen 8b ist mit der in den Fig. 2 und 4 dargestellten Leitungsschiene 13 verbunden, die den Heizstrom einzelnen Heizstufen zuführt. Jeder einzelne der Heizstufen entnimmt über ihren Leistungstransistor 11 bis zu etwa 40 Ampere der über das Leiterblech 13 zugeführten Strommenge.

In Fig. 4 ist eine weitere perspektivische Detailansicht des Seitenholms 5 und der in die kastenförmige Öffnung des Seitenholms 5 einsteckbaren Steuerschaltung dargestellt.

Im oberen Bereich der Fig. 4 sind auf der Oberfläche des Seitenholms 5 zwei der Fensteröffnungen 7 zu erkennen. Diese Fensteröffnungen sind so angeordnet, dass sie ober- und unterhalb der Kühlelemente 6 liegen, wenn die Steuerschaltung in den Seitenholm 5 eingesetzt ist.

Innerhalb der kastenförmigen Öffnung des Seitenholms 5 sind die Anschlusslaschen 15 der Heizelemente 2 zu erkennen. Für jede Heizstufe ist eine Anschlusslasche 15 vorgesehen.

In der unteren Hälfte der Fig. 4 ist die in den Seitenholm 5 einsetzbare Steuerschaltung dargestellt. Nur einer der Leistungstransistoren 11 ist in diesem Fall zur besseren Deutlichkeit des Aufbaus mit einem Kühlelement 6 versehen. Im übrigen entspricht der Aufbau der Steuerschaltung der in Verbindung mit Fig. 2 beschriebenen Steuerschaltung.

Figur 5 zeigt eine weitere Ausführungsform der vorliegenden Erfindung. Dabei sind in den Fig. 5a, 5b und 5c verschiedene Detailansichten wiedergegeben, in denen sich die Ausführungsform besonders von der vorhergehend beschriebenen unterscheidet.

In Fig. 5a ist eine leicht modifizierte Gestaltung des Seitenholms 5 zu erkennen. Dabei entspricht die Anordnung der Fensteröffnungen 7 der zuvor beschriebenen Ausführungsform. Um den Luftstrom gezielter zu beeinflussen, sind zwischen Fensteröffnungen 7 in dem Seitenholm 5 Wände vorgesehen, soweit dies ohne ein Einsetzen der Steuerschaltung in den Seitenholmen 5 zu behindern möglich ist. Dabei werden alle Zwischenräume, die auf der Oberseite zwischen den Fenstern und auf der dem Heizelement zugewandten Seite liegen mit zusätzlichen Wänden 18 verschlossen. Auf diese Weise wird ein ungezieltes Umherströmen von Luft im Betrieb vermieden.

In den Fig. 5a und 5b ist die Luftführung zwischen den Fensteröffnungen 7 im Detail dargestellt. Dazu ist zur gezielten Luftführung ein Luftleitelement 17 in die zwischen den Fensteröffnungen 7 liegenden Bereiche eingesetzt. Wie in Fig. 5b zu erkennen, erlaubt ein Y-förmiges Spoilerelement ein besseres Umströmen der Kühlrippen des U-förmigen Kühlelementes 6. Dabei sind die Kühlrippen des Kühlelementes 6 jeweils benachbart zu den Fensteröffnungen 7 angeordnet.

In Fig. 5b ist außerdem die Platine 10 mit dem Leistungstransistor 11 angedeutet.

Figur 5c zeigt eine entsprechende Ausgestaltung des Kühlelementes 6. Während in der zuvor beschriebenen Ausführungsform das im wesentlichen U-förmig ausgebildete Kühlelement 6 mit seiner U-förmigen Seite senkrecht auf der Platine steht, ist in dieser Ausführungsform der Kühlkörper 6 so angeordnet, dass die U-Form mit ihrer Unterseite parallel zur Platine 10 angeordnet ist. Entsprechend ist das Y-förmige Luftleitelement 17 so angeordnet, dass es aus der den Heizelementen zugewandten Seite des Seitenholmes 5 in Richtung auf die Steuervorrichtung ragt. Bei Verwendung eines Kühlkörpers 6 gemäß der ersten Ausführungsform, können entsprechende Luftleitelemente an den seitlichen Begrenzungen zwischen den gegenüberliegenden Fensteröffnungen 7 angeordnet sein.

In der in Fig. 5c dargestellten Ausführungsform beträgt die Breite b1 einer Kühlrippe etwa 3 mm, während der Abstand b2 zwischen den Kühlrippen etwas weniger, ungefähr 2,5 mm beträgt. Der Kühlkörper wird vorzugsweise aus Aluminium oder Kupfer gefertigt.

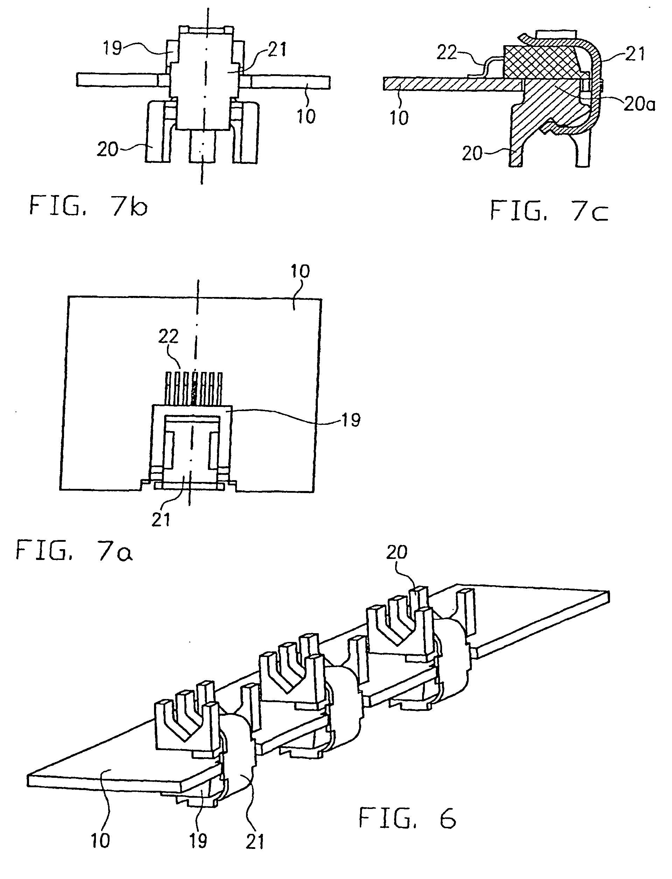

In den Figuren 6 und 7 ist eine weitere Ausführungsform einer erfindungsgemäßen Steuervorrichtung dargestellt. In dieser Ausführungsform sind insbesondere die Leistungstransistoren und die Kühlkörper unterschiedlich zu den bisherigen Ausführungsformen ausgebildet. Die Kühlkörper 20 sind in dieser Ausführungsform in einer anderen Weise an die Leistungstransistoren angebunden. In den bisherigen Ausführungsformen sind an den Leistungstransistoren 11 Kühlfahnen angeformt, die an einer Seite aus dem Leistungstransistor herausragen. An diesen Kühlfahnen werden die Kühlkörper der oben beschriebenen Ausführungsformen befestigt. Dabei sind die Kühlfahnen der Leistungstransistoren mit der Leiterplatte verlötet. In der im folgenden beschriebenen Ausführungsform werden die Kühlkörper mittels einer Klemmbefestigung an den Transistor angebunden. In den Fig. 6 und 7 ist dargestellt, daß die Kühlkörper 20 dieser Ausführungsform eine besondere Ausgestaltung aufweisen. Um ein Eingreifen einer Klammer 21 zu ermöglichen, weist der Kühlkörper 20 eine unsymmetrische Ausgestaltung der Kühlrippen auf. Dazu sind auf einer Seite des vorzugsweise U-förmig ausgestalteten Kühlkörpers weniger Rippen als üblich vorgesehen, um ein Eingreifen einer Klammer 21 zu ermöglichen. Die Klammer umgreift vorzugsweise den Leistungstransistor 19 und den Kühlkörper 20 von außen und befestigt so den Kühlkörper 20 an der Steuervorrichtung und dem Transistor 19.

Diese Ausführungsform ist insbesondere für Leistungstransistoren in SMD-Ausführung vorteilhaft. Transistoren in SMD-Ausführung weisen bauartbedingt keine Kühlfahnen auf, an denen der Kühlkörper befestigt werden kann. Um den Kühlkörper mit der Unterseite des Leistungstransistors 19 verbinden zu können, ist in der Leiterplatine eine Bohrung vorgesehen und diese Bohrung weist vorzugsweise einen Durchmesser von ungefähr 7,5 mm auf.

Der Kühlkörper 20 weist dementsprechend einen Zapfen 20a an seiner Unterseite auf. Dieser Zapfen ragt in der dargestellten Ausführungsform in die entgegengesetzte Richtung der einzelnen Kühlrippen. Der Durchmesser des Zapfens 20a beträgt vorzugsweise etwa 7 mm.

Der an dem Kühlkörper 20 angeformte Zapfen 20a ragt durch die Bohrung in der Platine 10 und kontaktiert direkt den Transistor 19.

Dieser Aufbau ist in den Fig. 7a, 7b und 7c im Detail dargestellt. Die Fig. 7a stellt eine Aufsicht auf die Platine 10 mit dem Leistungstransistor 11 dar. Der Leistungstransistor 11 ist am Rand der Platine 10 angeordnet, so daß die Klammer 21 zum Befestigen des Kühlkörpers 20 leicht zu befestigen ist. Damit die Klammer 21, die um die Platine 10 herumgreift, keine größere Bautiefe der Platine 10 erfordert, kann an dieser Stelle die Platine eine leichte Ausbuchtung aufweisen. Die Tiefe dieser Ausbuchtung entspricht vorzugsweise in etwa der Dicke der Klammer 21 in diesem Bereich. Vorzugsweise ist der Transistor 19 so angeordnet, daß Anschlußkontakte 22 zu dem entgegengesetzten Rand der Platine 10 weisen.

In Fig. 7b ist eine seitliche Ansicht wiedergegeben. Figur 7c stellt eine Schnittansicht entlang der Schnittlinie A-A in Fig. 7b dar. Fig. 7c zeigt, daß der Kühlkörper 20 und die Feder 21 geometrisch so aufeinander abgestimmt sind, daß eine lagegerechte Fixierung mit optimalen Druckpunkt gewährleistet ist.

## Patentansprüche

1. Elektrische Heizvorrichtung, insbesondere als elektrische Zusatzheizung für Kraftfahrzeuge, mit:
mehreren zu einem Heizblock zusammengesetzten Heizelementen (2), wobei der Heizblock in einem rechteckigen Rahmen (3, 4, 5) gehalten ist, und
einer Steuervorrichtung zur Ansteuerung der Heizelemente (2), wobei die Steuervorrichtung mit dem in dem Rahmen (3, 4, 5) gehaltenen Heizblock eine bauliche Einheit bildet und auf einer Platine (10) angeordnete Leistungstransistoren (11) aufweist, die jeweils die den einzelnen Heizelementen (2) zuzuführenden Strommenge einstellen,
**dadurch gekennzeichnet, dass**
die Steuervorrichtung eine Stromschiene (13) zur Stromzuführung von einem Anschlussbolzen (8b) zu den einzelnen Leistungstransistoren (11) umfasst.

2. Elektrische Heizvorrichtung nach Anspruch 1, wobei der Ausgang jedes Leistungstransistors (11) mit dem diesem Leistungstransistor (11) zugeordneten Anschluss (14) für die Heizelemente (2) einer Heizstufe verbunden ist.

3. Elektrische Heizvorrichtung nach Anspruch 1 oder 2, wobei der Anschlussbolzen (8b) aus einem Gehäuse der Steuervorrichtung herausragt.

4. Elektrische Heizvorrichtung nach einem der Ansprüche 1 bis 3, wobei
der Rahmen aus sich gegenüberliegenden Längsholmen (3) und senkrecht zu diesen angeordneten Seitenholmen (4,5) gebildet ist,
zumindest einer der Seitenholme (5) als einseitig offener Kasten ausgebildet ist, in den die Steuervorrichtung einsetzbar ist,
Fensteröffnungen (7) in dem Seitenholm (5) vorgesehen sind und
die Kühlelemente (6) der Leistungstransistoren (11) bei eingesetzter Steuervorrichtung jeweils zwischen sich gegenüberliegenden Fensteröffnungen (7) liegen.

5. Elektrische Heizvorrichtung nach einem der Ansprüche 1 bis 4, wobei die Platine (10) der Steuervorrichtung nur einseitig mit Bauelementen bestückt ist.

6. Elektrische Heizvorrichtung nach Anspruch 4 oder 5, wobei die Platine (10) senkrecht zur Rahmenebene angeordnet und im wesentlichen mit der Länge des Seitenholms (5) ausgebildet ist.

7. Elektrische Heizvorrichtung nach einem der Ansprüche 4 bis 6, wobei die Steuervorrichtung in dem Seitenholm (5) mittels elektrischer Anschlussfahnen (15) fixierbar ist, die von den Heizelementen (2) in das Innere dieses Seitenholms (5) ragen.

8. Elektrische Heizvorrichtung nach Anspruch 7, wobei den Anschlussfahnen (15) entsprechende Federelemente (14) zur Aufnahme der Anschlussfahnen (15) auf der Platine (10) zugeordnet sind.

## Claims

1. An electric heating device, especially for use as a supplementary electric heating for motor vehicles, comprising:
a plurality of heating elements (2) combined so as to form a heating block, the heating block being held in a rectangular frame (3, 4, 5), and
a control device for controlling the heating elements (2), said control device defining a structural unit with the heating block held in the frame (3, 4, 5) and being provided with power transistors (11) which are arranged on a printed circuit board (10), each of said power transistors (11) adjusting the amount of power to be supplied to the individual heating elements (2),
**characterized in that**
the control device comprises a power rail (13) for supplying power from a connecting pin (8b) to the individual power transistors (11).

2. An electric heating device according to claim 1, wherein the output of each power transistor (11) is connected to the connection (14) assigned to said power transistor (11) and used for the heating elements (2) of a heating stage.

3. An electric heating device according to claim 1 or 2, wherein the connecting pin (8b) projects from a housing of the control device.

4. An electric heating device according to any one of claims 1 to 3, wherein
the frame is defined by opposed longitudinal bars (3) and lateral bars (4, 5) arranged at right angles to said longitudinal bars (4, 5),
at least one of said lateral bars (5) is implemented as a box which is open on one side thereof and which is adapted to have the control device inserted therein,
window openings (7) are provided in said lateral bar (5), and
the cooling elements (6) of the power transistors (11) are located between respective opposed window openings (7) in the inserted condition of the control device.

5. An electric heating device according to any one of claims 1 to 4, wherein the printed circuit board (10) of the control device is equipped with components on only one side thereof.

6. An electric heating device according to claim 4 or 5, wherein the printed circuit board (10) is arranged at right angles to the plane of the frame and is implemented such that its length corresponds substantially to that of the lateral bar (5).

7. An electric heating device according to any one of claims 4 to 6, wherein the control device is adapted to be fixed in the lateral bar (5) by means of electric connection lugs (15) which project from the heating elements (2) into the interior of said lateral bar (5).

8. An electric heating device according to claim 7, wherein spring elements (14) for receiving the connection lugs (15) are provided on the printed circuit board (10), said spring elements (14) being complementary to the connection lugs (15).

## Revendications

1. Un dispositif de chauffage électrique, en particulier en tant que chauffage d'appoint pour des véhicules automobiles, comportant :
une pluralité d'éléments chauffants (2) assemblés en un bloc chauffant, le bloc chauffant étant maintenu dans un cadre (3, 4, 5) rectangulaire, et
un dispositif de commande pour la commande des éléments chauffants (2), le dispositif de commande avec le bloc chauffant, maintenu dans le cadre (3, 4, 5), formant un ensemble de construction et présentant des transistors de puissance (11) disposés sur une platine (10), qui règlent chacun le courant alimentant les éléments chauffants (2) respectifs, **caractérisé en ce que** le dispositif de commande comprend un rail conducteur (13) pour la transmission du courant d'un bouchon de raccordement (8b) aux transistors de puissance (11) respectifs.

2. Dispositif de chauffage électrique selon la revendication 1, où la sortie de chaque transistor de puissance (11) est reliée à la jonction (14) associée à ce transistor de puissance (11) pour l'élément chauffant (2) par un étage de chauffage.

3. Dispositif de chauffage électrique selon la revendication 1 ou 2, où le bouchon de raccordement (8b) saille hors d'un boîtier du dispositif de commande.

4. Dispositif de chauffage selon l'une des revendications 1 à 3, où le cadre est formé de longerons (3) opposés et de montants latéraux (4, 5) disposés perpendiculairement à ceux-ci,
au moins un des montants latéraux (5) est réalisé sous forme de caisson ouvert sur un côté, dans lequel le dispositif de commande peut être inséré,
des ouvertures formant fenêtre (7) sont prévues dans le montant latéral (5), et
les éléments de refroidissement (6) des transistors de puissance (11) sont chacun situés entre des ouvertures formant fenêtre (7) opposées lorsque le dispositif de commande est inséré.

5. Dispositif de chauffage électrique selon l'une des revendications 1 à 4, la platine (10) du dispositif de commande n'étant munie de composants que sur une face.

6. Dispositif de chauffage électrique selon l'une des revendications 4 ou 5, la platine (10) étant disposée perpendiculairement au plan de cadre et étant réalisée sensiblement à la longueur du montant latéral (5).

7. Dispositif de chauffage électrique selon l'une des revendications 4 à 6, le dispositif de commande étant susceptible d'être fixé dans le montant latéral (5) à l'aide de drapeaux de raccordement électrique (15), pénétrant à l'intérieur de ce montant latéral (5) depuis les éléments de chauffage (2).

8. Dispositif de chauffage électrique selon la revendication 7, des éléments formant ressort (14), correspondant aux drapeaux de raccordement (15), étant prévus pour supporter les drapeaux de raccordement (15) sur la platine (10).
